(19) Europäisches Patentamt / European Patent Office / Office européen des brevets

(11) **EP 2 166 131 A1**

(12) **EUROPEAN PATENT APPLICATION**
published in accordance with Art. 153(4) EPC

(43) Date of publication:
24.03.2010 Bulletin 2010/12

(51) Int Cl.:
*C23C 16/40* (2006.01)  *H01L 21/31* (2006.01)

(21) Application number: 06797363.6

(22) Date of filing: 04.09.2006

(86) International application number:
PCT/JP2006/317438

(87) International publication number:
WO 2007/029637 (15.03.2007 Gazette 2007/11)

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK RS

(30) Priority: 06.09.2005 JP 2005258402

(71) Applicant: Canon Anelva Corporation
Asao-ku
Kawasaki-shi
Kanagawa 215-8550 (JP)

(72) Inventors:
• JUN, Keeyoung
Kanagawa;2368515 (JP)
• OOBA, Yoshiyuki
Kanagawa;2368515 (JP)
• SAKAMOTO, Hitoshi
Kanagawa;2368515 (JP)
• OGURA, Yuzuru
Kanagawa;2368515 (JP)
• SEKINE, Takayuki
Kanagawa;2368515 (JP)

(74) Representative: Musker, David Charles et al
R.G.C. Jenkins & Co
26 Caxton Street
London SW1H 0RJ (GB)

(54) **THIN FILM MANUFACTURING APPARATUS AND THIN FILM MANUFACTURING METHOD**

(57) A chamber (1) is supplied with an operation gas (17) containing chlorine, and the chamber is also supplied with oxygen and hydrogen to increase the pressure in the chamber (1) to lengthen the retention time, then, an Al member (11) to be etched is etched by chlorine radical, and a precursor $AlCl_3$ composed of Al ingredient included in the member and halogen Cl is generated. While generating an intermediate of $AlX_2$ from the precursor $AlX_3$, a film is formed of an $Al_2O_3$ ingredient generated by reaction of oxygen, hydrogen and $AlX_2$ on a substrate (3). Thus, an Al oxide thin film is surely manufactured under a low temperature environment.

**Description**

**TECHNICAL FIELD**

The present invention relates to a thin-film producing apparatus which can form a film of an Al oxide component, and to a method of producing a thin film.

**BACKGROUND ART**

At present, in a field of manufacturing a semiconductor or the like, a film-forming method with the use of a plasma CVD (Chemical Vapor Deposition) apparatus is known. The plasma CVD apparatus is an apparatus for depositing a metal thin film or the like, by converting a gas of an organometallic complex or the like which is a material of the film and has been introduced in a chamber, into a plasma state by using a high-frequency wave that is incident from a high-frequency antenna, and by promoting a chemical reaction on the surface of a substrate by an active excited atom in the plasma.

In contrast, the present inventors developed a plasma CVD apparatus (hereinafter referred to as a new type of plasma CVD apparatus) and a film-forming method (see following Patent Document 1, for instance), which are followed. In the plasma CVD apparatus and the film-forming method, an etching object member made from a metal component that forms a high-vapor-pressure halide, and is expected to form a film, is provided in a chamber, a halogen gas converted into a plasma state to etch above described etching object member by the radical of halogen, thereby generating a precursor of a halide of the metal component, and simultaneously only the metal component of the precursor deposit on the substrate.

The above described new type of the plasma CVD apparatus is structured so as to form the metal film on the substrate by controlling the temperature of the substrate to be lower than that of the etching object member to be a source of a metal to be deposited, at a predetermined low pressure (0.1 Torr to 0.2 Torr, for instance). For instance, when the metal of the etching object member is represented by M, and a halogen gas is represented by $Cl_2$, a thin film of M can be formed on the above described substrate by controlling the etching object member to a high temperature (300°C to 700°C, for instance), and controlling the substrate to a low temperature (approximately 200°C, for instance). This process is considered to be caused by the following reactions.

(1) dissociation reaction of plasma; $Cl_2 \rightarrow 2Cl^*$
(2) etching reaction; $M + Cl^* \rightarrow MCl$ (g)
(3) adsorption reaction onto substrate; $MCl$ (g) $\rightarrow MCl$ (ad)
(4) deposition reaction; $MCl$ (ad) $+ Cl^* \rightarrow M + Cl_2 \uparrow$

Here, $Cl^*$ represents a radical of Cl, (g) represents a gas state, and (ad) represents an adsorbed state respectively.

The above described new type of the CVD apparatus appropriately keeps a ratio of MCl to $Cl^*$ to make a deposition reaction appropriately proceed. Specifically, a flow rate of $Cl_2$ gas, a pressure, a power, temperatures of the substrate and the etching object member, a distance between the substrate and the etching object member, and the like as film-forming conditions are appropriately set, and thereby the ratio of MCl and $Cl^*$ can be controlled to be approximately the same, and M is detected without lowering a film-forming speed, and besides, without making $Cl^*$ excessively etch the substrate.

It is considered to prepare a thin film of aluminum oxide ($Al_2O_3$) to be used in applications for a semiconductor material or the like, by using the above described new type of the CVD apparatus. In the case of using Al for the etching object member, MCl in the reaction formula becomes $AlX_3$. However, $AlX_3$ is stable, so that it is difficult to cause the etching (reducing) reaction due to $Cl^*$, under present circumstances. For this reason, the compatibility with a raw material of oxygen or the like is also important, and such a technology has not been established as to unfailingly produce the thin film of aluminum oxide in the new type of the CVD apparatus.

Patent Document 1: Japanese Patent Application Laid-Open No. 2003-147534

**DISCLOSURE OF THE INVENTION**

The present invention is designed with respect to the above described circumstances, and the object is to provide a thin-film producing apparatus and a method of producing the thin film which can unfailingly produce a thin film of AlN with the use of a new type of a CVD apparatus.

In order to achieve the above described object, a thin-film producing apparatus of the present invention according to claim 1 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; feeding means for feeding oxygen and hydrogen into the inside of the chamber; and a controlling means for generating a intermediate product of $AlX_2$ from the precursor $AlX_3$ by lowering temperature of the substrate side less than temperature of the etching object member and simultaneously controlling the staying period of fluid, and forming Al oxide component generated from reaction of the oxygen and the hydrogen, fed by the feeding means, and the $AlX_2$, on the substrate side.

Thus, the thin-film producing apparatus controls the staying period of the fluid to form the intermediate product of $AlX_2$, makes the Al oxide component which has been produced through the reaction of oxygen and hydrogen with $AlX_2$ form its film on the substrate side, accordingly facilitates a reduction by the halogen radical, and can unfailingly produce a thin film of Al oxide at low temperatures.

In order to achieve the above described object, a thin-film producing apparatus of the present invention according to claim 2 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; feeding means for feeding oxygen and hydrogen into the inside of the chamber; and a controlling means for generating a intermediate product of AlX from the precursor $AlX_3$ by lowering temperature of the substrate side less than temperature of the etching object member and simultaneously controlling the staying period of fluid, and forming Al oxide component generated from reaction of the oxygen and the hydrogen, fed by the feeding means, and the AlX, on the substrate side.

Thus, the thin-film producing apparatus controls the staying period of the fluid to form the intermediate product of AlX, makes the Al oxide component which has been produced through the reaction of oxygen and hydrogen with AlX form its film on the substrate side, accordingly facilitates a reduction by the halogen radical, and can unfailingly produce a thin film of Al oxide at low temperatures.

The thin-film producing apparatus of the present invention according to claim 3 is **characterized in that** the feeding means includes a function for adjusting an amount of oxygen and hydrogen according to a state of the precursor $AlX_3$, and the control means includes a function for adjusting the amount of oxygen and hydrogen to a desired state to make the Al component and the Al oxide component intermixed on the substrate, in the thin-film producing apparatus according to claim 1.

Thus, the thin-film producing apparatus adjusts the amount of oxygen and hydrogen to a desired state, and thereby can produce the thin film on the substrate, in which the Al component and the Al oxide component are intermixed.

In order to achieve the above described object, a thin-film producing apparatus of the present invention according to claim 4 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; feeding means for feeding $H_2O$ into the inside of the chamber; and a controlling means for generating a intermediate product of $AlX_2$ from the precursor $AlX_3$ by lowering temperature of the substrate side less than temperature of the etching object member and simultaneously controlling the staying period of fluid, and forming Al oxide component generated from reaction of the $H_2O$ fed by the feeding means, and the $AlX_2$, on the substrate side.

Thus, the thin-film producing apparatus controls the staying period of the fluid to form the intermediate product of $AlX_2$, makes the Al oxide component which has been produced through the reaction of $H_2O$ with $AlX_2$ form its film on the substrate side, accordingly facilitates a reduction by the halogen radical, and can unfailingly produce a thin film of Al oxide at low temperatures.

In order to achieve the above described object, a thin-film producing apparatus of the present invention according to claim 5 is a thin-film producing apparatus comprising: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; feeding means for feeding $H_2O$ into the inside of the chamber; and a controlling means for generating a intermediate product of AlX from

the precursor $AlX_3$ by lowering temperature of the substrate side less than temperature of the etching object member and simultaneously controlling the staying period of fluid, and forming Al oxide component generated from reaction of the $H_2O$ fed by the feeding means, and the AIX, on the substrate side.

Thus, the thin-film producing apparatus controls the staying period of the fluid to form the intermediate product of AIX, makes the Al oxide component which has been produced through the reaction of $H_2O$ with AIX form its film on the substrate side, accordingly facilitates a reduction by the halogen radical, and can unfailingly produce a thin film of Al oxide at low temperatures.

The thin-film producing apparatus of the present invention according to claim 6 is **characterized in that** the feeding means includes the function for adjusting an amount of $H_2O$ according to a state of the precursor $AlX_3$, and the control means includes a function for adjusting an amount of $H_2O$ to a desired state to make the Al component and the Al oxide component intermixed on the substrate, in the thin-film producing apparatus according to claim 4.

Thus, the thin-film producing apparatus adjusts the amount of $H_2O$ to the desired state, and thereby can produce the thin film in which the Al component and the Al oxide component are intermixed on the substrate.

The thin-film producing apparatus of the present invention according to claim 7 is **characterized in that** the function of the control means for making the Al component and the Al oxide component intermixed is a function of alternately stacking the Al component and the Al oxide component on each other, in the thin-film producing apparatus according to claim 3.

Thus, the thin-film producing apparatus can produce the thin film in which the Al component and the Al oxide component are alternately stacked on each other.

The thin-film producing apparatus of the present invention according to claim 8 is **characterized in that** the staying period is derived from a value calculated by dividing the volume of the chamber by a product of a flow rate of the action gas, a temperature in the atmosphere and a pressure in the chamber, and the plasma generating means and the control means control the staying period by increasing the pressure in the chamber, in the thin-film producing apparatus according to claim 1.

Thus, the thin-film producing apparatus increases the pressure in the chamber, and thereby can form the film of the Al oxide component on the substrate side.

The thin-film producing apparatus of the present invention according to claim 9 is **characterized in that** the halogen contained in the action gas is chlorine, in the thin-film producing apparatus according to claim 1.

Thus, inexpensive chlorine can be used.

The thin-film producing apparatus of the present invention according to claim 10 is **characterized in that** the thin-film producing apparatus according to claim 3 comprises: $NH_2$ forming means for forming hydrogen and $NH_2$ which is a compound of hydrogen, in the inner part of the chamber; and AlN-production control means which controls a temperature of the substrate side so as to be lower than a temperature of the etching object member and simultaneously controls the staying period of the fluid to make the precursor $AlX_3$ form an intermediate product of $AlX_2$, and then makes an A;N component which has been produced through a reaction of $NH_2$ formed by the forming means with $AlX_2$ form its film on the substrate side, wherein the control means has a function of producing a thin film of AlN on the substrate on which a film of the Al oxide component has been formed.

Thus, the thin-film producing apparatus can produce the thin film of AlN after having formed the film of the Al oxide component, which can be a gate metal having a high dielectric constant.

In order to achieve the above described object, a method of producing a thin film of the present invention according to claim 11 is a method of producing a thin film comprising: feeding oxygen and hydrogen into a chamber, while feeding an action gas containing a halogen into the chamber; etching an etching object member containing Al with a halogen radical by controlling a staying period of a fluid to form a precursor $AlX_3$ formed by an Al component contained in the etching object member and the halogen X; and forming an Al oxide component which has been produced through a reaction of the oxygen and the hydrogen with $AlX_2$ on a substrate side, while producing an intermediate product of $AlX_2$ from the precursor $AlX_3$.

Thus, the method of producing the thin-film controls the staying period of the fluid to form the intermediate product of $AlX_2$, makes the Al oxide component which has been produced through the reaction of oxygen and hydrogen with $AlX_2$ form its film on the substrate side, accordingly facilitates a reduction by the halogen radical, and can unfailingly produce a thin film of Al oxide at low temperatures.

In order to achieve the above described object, a method of producing a thin film of the present invention according to claim 12 is a method of producing a thin film comprising: feeding oxygen and hydrogen into a chamber, while feeding an action gas containing a halogen into the chamber; etching an etching object member containing Al with a halogen radical by controlling a staying period of a fluid to form a precursor $AlX_3$ formed by an Al component contained in the etching object member and the halogen X; and forming an Al oxide component which has been produced through a reaction of the oxygen and the hydrogen with AlX on a substrate side, while producing an intermediate product of AlX from the precursor $AlX_3$.

Thus, the method of producing the thin-film controls the staying period of the fluid to form the intermediate product of AlX, makes the Al oxide component which has been produced through the reaction of oxygen and hydrogen with AlX form its film on the substrate side, accordingly facilitates a reduction by the halogen radical, and can unfailingly produce a thin film of Al oxide at low temperatures.

In order to achieve the above described object, a method of producing a thin film of the present invention according to claim 13 is a method of producing a thin film comprising: feeding $H_2O$ into a chamber, while feeding an action gas containing a halogen into the chamber; etching an etching object member containing Al with a halogen radical by controlling a staying period of a fluid to form a precursor $AlX_3$ formed by an Al component contained in the etching object member and the halogen X; and forming an Al oxide component which has been produced through a reaction of the $H_2O$ with $AlX_2$ on a substrate side, while producing an intermediate product of $AlX_2$ from the precursor $AlX_3$.

Thus, the method of producing the thin-film controls the staying period of the fluid to form the intermediate product of $AlX_2$, makes the Al oxide component which has been produced through the reaction of $H_2O$ with $AlX_2$ form its film on the substrate side, accordingly facilitates a reduction by the halogen radical, and can unfailingly produce a thin film of Al oxide at low temperatures.

In order to achieve the above described object, a method of producing a thin film of the present invention according to claim 14 is a method of producing a thin film comprising: feeding $H_2O$ into a chamber, while feeding an action gas containing a halogen into the chamber; etching an etching object member containing Al with a halogen radical by controlling a staying period of a fluid to form a precursor $AlX_3$ formed by an Al component contained in the etching object member and the halogen X; and forming an Al oxide component which has been produced through a reaction of the $H_2O$ with AlX on a substrate side, while producing an intermediate product of AlX from the precursor $AlX_3$.

Thus, the method of producing the thin film controls the staying period of the fluid to form the intermediate product of AlX, makes the Al oxide component which has been produced through the reaction of $H_2O$ with AlX form its film on the substrate side, accordingly facilitates a reduction by the halogen radical, and can unfailingly produce the thin film of Al oxide at low temperatures.

The method of producing the thin film of the present invention according to claim 15 is **characterized in that** the method of producing the thin film according to claim 11 includes adjusting an amount of oxygen and hydrogen according to a state of the precursor $AlX_3$, and producing the thin film on the substrate, in which the Al component and the Al oxide component are intermixed.

Thus, the method of producing the thin film adjusts the amount of oxygen and hydrogen to a desired state, and thereby can produce a thin film on the substrate, in which the Al component and the Al oxide component are intermixed.

The method of producing the thin film of the present invention according to claim 16 is **characterized in that** the method of producing the thin film according to claim 13 includes adjusting an amount of $H_2O$ according to a state of the precursor $AlX_3$, and producing the thin film on the substrate, in which the Al component and the Al oxide component are intermixed.

Thus, the method of producing the thin film adjusts the amount of $H_2O$ to the desired state, and thereby can produce the thin film on the substrate, in which the Al component and the Al oxide component are intermixed.

The method of producing the thin film of the present invention according to claim 17 is **characterized in that** the method of producing the thin film according to claim 11 includes producing a thin film of $Al_2O_3$ and producing a thin film in which an AlN component and an Al component are stacked, on a substrate on which the thin film of $Al_2O_3$ has been produced.

Thus, the method of producing the thin film can produce the thin film of AlN after having formed $Al_2O_3$, which can be a gate metal having a high dielectric constant.

The method of producing the thin film of the present invention according to claim 18 is **characterized in that** the halogen contained in the action gas is chlorine, in the method of producing the thin film according to claim 11.

Thus, inexpensive chlorine can be used.

A thin-film producing apparatus according to the present invention is a thin-film producing apparatus which can unfailingly produce a thin film of AL oxide at low temperatures by using a new type of a CVD apparatus.

In addition, a method of producing a thin film according to the present invention is the method of producing the thin film, which can unfailingly produce the thin film of Al oxide at low temperatures by using the new type of the CVD apparatus.

## BRIEF DESCRIPTION OF THE DRAWINGS

FIG. 1 is a schematic side view of a thin-film producing apparatus according to one embodiment of the present invention;
FIG. 2 is a graph showing a light-emitting state of plasma;
FIG. 3 is a schematic side view of a thin-film producing apparatus according to another embodiment of the present invention; and

FIG. 4 is a schematic side view of a thin-film producing apparatus according to another embodiment of the present invention.

**BEST MODES FOR CARRYING OUT THE INVENTION**

Embodiments according to the present invention will now be described in detail below with reference to the drawings.

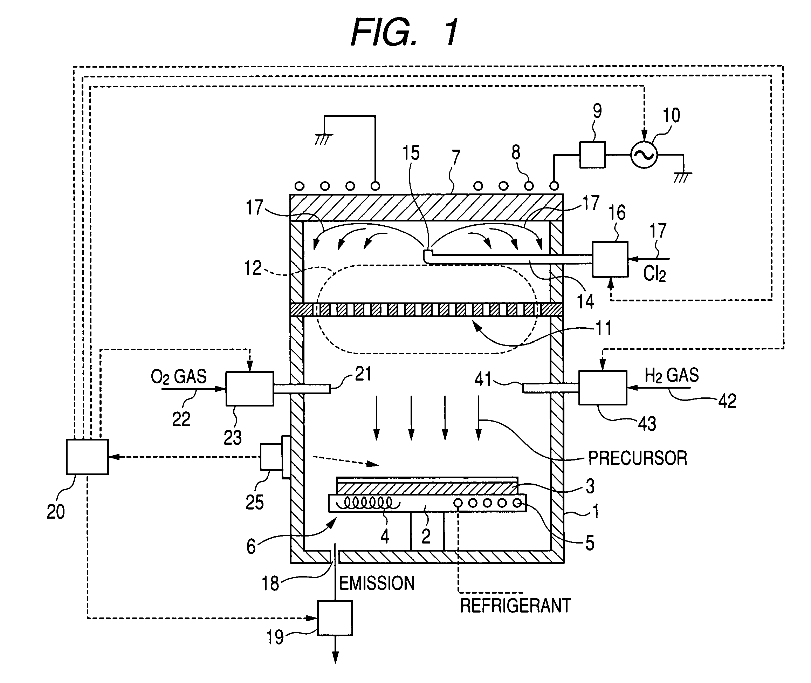

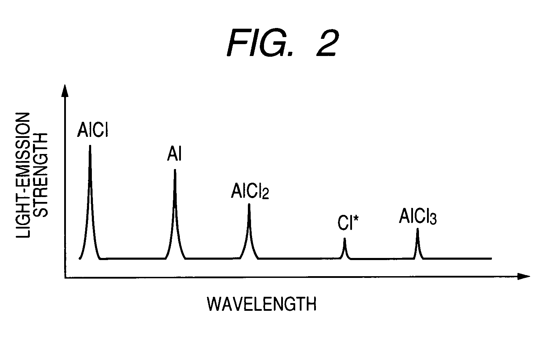

FIG. 1 illustrates a schematic side view of a thin-film producing apparatus according to one embodiment of the present invention; and FIG. 2 shows a graph showing a light-emitting state of plasma.

As is illustrated in FIG. 1, a support table 2 is provided in the vicinity of the bottom part of a chamber 1, for instance, made from a ceramic (made from insulation material), which has been formed to be a cylindrical shape, and a substrate 3 is mounted on the support table 2. Temperature control means 6 which includes a heater 4 and refrigerant circulating means 5 is provided on the support table 2, and the support table 2 is controlled to a predetermined temperature (such temperature that substrate 3 is kept at 100°C to 300°C, for instance) by the temperature control means 6. Incidentally, the shape of the chamber is not limited to the cylindrical shape, but the chamber can employ, for instance, a rectangular shape as well.

The upper face of the chamber 1 is formed to be an opening portion, and the opening portion is blocked with a tabular ceiling board 7 made from an insulation material (made from ceramic, for instance). A plasma antenna 8 for forming a plasma state in the inside of the chamber 1 is provided above the ceiling board 7, and the plasma antenna 8 is formed to be a planar ring shape parallel to the plane of the ceiling board 7. A matching box 9 and a power source 10 are connected to the plasma antenna 8, and feed a high-frequency power thereto. Plasma generating means for generating an induction plasma is constituted by the plasma antenna 8, the matching box 9 and the power source 10.

An etching object member (member to be etched) 11 made from aluminum (Al) is held by the chamber 1, and is arranged in between the substrate 3 and the ceiling board 7 in a discontinuous state with respect to an electric flow of the plasma antenna 8. The etching object member 11 is formed, for instance, to be a grid shape and in a structurally discontinuous state with respect to the peripheral direction which is the direction of the electric flow of the plasma antenna 8.

As for a configuration of the etching object member which is set at a discontinuous state with respect to the electric flow of the plasma antenna 8, it is also possible to form the etching object member into a mesh shape, or to form a plurality of long protrusions in the inner peripheral side of the ring.

One line of a gas nozzle 14 for feeding an action gas 17 containing chlorine as a halogen (gas: $Cl_2$ gas diluted to predetermined concentration by He) into the inner part of the chamber 1 is provided in a cylinder portion of the chamber 1 above the etching object member 11. The gas nozzle 14 extends to the central part of the chamber 1, and the tip is directed toward the upside and is made to be a gas blow hole 15. Gases of He and $Cl_2$ are individually controlled and sent to a flow rate controller 16, and $Cl_2$ gas 17 which has been diluted by He is sent to the gas nozzle 14 through the flow rate controller 16 which controls the flow rate and the pressure (action gas feeding means).

The shape and the arrangement of the gas nozzle 14 is not limited to the illustrated example, but for instance, a plurality of gas nozzles may be connected in the peripheral direction of the chamber 1 at equal spaces (on eight spots, for instance). Fluorine, bromine, iodine or the like can be applied to the halogen contained in the action gas. By using chlorine as the halogen, the thin film can be produced with the use of inexpensive chlorine gas.

A nozzle 21 for feeding oxygen ($O_2$) is provided on the cylinder portion of the chamber 1, and $O_2$ gas 22 is fed into the chamber 1 from the nozzle 21 through a flow rate controller 23 (feeding means). In addition, a nozzle 41 for feeding hydrogen ($H_2$) is provided on the cylinder portion of the chamber 1, and $H_2$ gas 42 is fed into the chamber 1 from the nozzle 41 through a flow rate controller 43 (feeding means).

A gas which does not participate in a film-forming process is emitted from a vent 18. The inside of the chamber 1 which has been sealed with the ceiling board 7 is kept at a predetermined pressure by a vacuum unit 19. An unshown valve of the vacuum unit 19 is controlled by control means 20, and the inside of the chamber is controlled to a desired pressure through adjustment by the valve. On the other hand, the control means 20 appropriately adjusts the output of the power source 10, and consequently can control an RF power.

A plasma spectroscope 25 for detecting a light-emitting state of plasma (light-emission strength with respect to wavelength, for instance) is provided on the cylinder portion of the chamber 1, determines the states (spectroscopic data) of a chlorine radical $Cl^*$, $AlX_3$, $AlX_2$ and $AlX$, which will be described later, based on the spectroscopic data, and sends the spectroscopic data to the control means 20. The control means 20 appropriately controls the flow rate of the action gas 17 and the flow rate of $NH_3$ based on the sent spectroscopic data.

The above described thin-film producing apparatus feeds the action gas 17 containing chlorine into the chamber 1, controls (prolongs) a staying period of a fluid, specifically, increases the pressure in the chamber 1, makes the chlorine radical etch the etching object member containing Al 11 to form a precursor $AlCl_3$ including an Al component contained in the etching object member and the halogen Cl, and simultaneously forms $AlCl_2$ and (or) AlCl of intermediate products. The thin-film producing apparatus also feeds $O_2$ gas 22 into the chamber 1 from the nozzle 21, simultaneously feeds $H_2$ gas 42 into the chamber 1 from the nozzle 41, makes the gases react with $AlCl_2$ and (or) AlCl in the plasma to form $Al_2O_3$, and forms a film of $Al_2O_3$ on a substrate 3 side.

The intermediate product of $AlCl_2$ (AlCl) is formed by prolonging the staying period of the fluid, and the intermediate product is made to react with $O_2$, $N_2$ (and chlorine radical $Cl^*$) to deposit the Al component of the precursor $AlX_3$ on the substrate 3 side as $Al_2O_3$. Accordingly, a reduction by the Cl radical can be facilitated, and the thin film of Al oxide can be unfailingly produced. The thin-film producing apparatus also can form $Al_2O_3$ with little amount of chlorine gas, because hydrogen $H_2$ provides a reducing action.

Here, the staying period of the fluid is controlled by increasing the pressure in the chamber 1. The staying period (t) of the fluid is expressed by

$$t = V/QTP.$$

Here, Q represents a flow rate of gas, T represents a temperature in the atmosphere, P represents a pressure {760 (Torr) /P (Total)}, and V represents a volume in the reaction atmosphere. Accordingly, prolonging the staying period of the fluid, by which the intermediate products of $AlCl_2$ and AlCl is formed, can be attained by any of operations of: raising the pressure P (Total: Torr) to decrease the P to a small value; reducing the flow rate; lowering the temperature; and increasing the volume. In the present embodiment, in consideration of the controllability or the like, the staying period is prolonged by raising the pressure P (Total: Torr).

When a metal thin film is produced by using a new type of a CVD apparatus, the pressure P (Total: Torr) is set in a range of 0.1 to 0.2 (Torr), but in the present embodiment, the pressure P (Total: Torr) is set, for instance, in a range of 0.5 to 1.0 (Torr), and the staying period is set at approximately 1.5 times longer. The pressure P is set by the control of an unshown valve of the vacuum unit 19.

The specific film-forming (deposition) state will now be described below.

$Cl_2$ gas 21 is fed to the inner part of the chamber 1, which has been controlled to 0.5 to 1.0 (Torr), from a gas nozzle 14. A plasma antenna 8 projects an electromagnetic wave to the inside of the chamber 1, ionizes the $Cl_2$ gas 21 to generate a plasma of the $Cl_2$ gas, and forms Cl radicals. The plasma is generated in a region illustrated by gas plasma 12. The reaction at this time can be expressed by the following formula:

$$Cl_2 - 2Cl^*$$

, wherein $Cl^*$ represents a chlorine radical.

The gas plasma 12 acts on an etching object member containing Al 11 to heat the etching object member 11 and simultaneously cause an etching reaction on Al. The reaction at this time can be expressed, for instance, by the following formula.

$$AlCl_3 \rightarrow AlCl_2 \rightarrow AlCl$$

The chlorine radical $Cl^*$ acts on $AlCl_3$, thereby causes the reaction of:

$$AlCl3 + Cl^* \rightarrow AlCl_2 + Cl_2\uparrow, \text{ and forms } AlCl_2 \text{ (control means).}$$

The chlorine radical $Cl^*$ also acts on $AlCl_2$, thereby causes the reaction of:

$$AlCl_2 + Cl^* \rightarrow AlCl + Cl_2\uparrow, \text{ and forms } AlCl \text{ (control means).}$$

$O_2$ gas 22 is fed into the chamber 1 from a nozzle 21, and simultaneously $H_2$ gas 42 is fed into the chamber 1 from a nozzle 41. In the plasma, the reaction of:

$$4AlCl_2 + 3O_2 + 2H_2 \rightarrow 2Al_2O_3 + 8Cl_2\uparrow \text{ occurs, and}$$

the film of $Al_2O_3$ is formed on a substrate 3.
In plasma, the reaction of:

$$4AlCl + 3O_2 + 2H_2 \rightarrow 2Al_2O_3 + 4Cl_2\uparrow \text{ also occurs, and}$$

the film of the $Al_2O_3$ is formed on the substrate 3.

In this way, the thin-film producing apparatus makes the Al component of a precursor $AIX_3$ react with $O_2$ and $H_2$ through easily reducible (unstable) intermediate products to form the film of $Al_2O_3$ on the substrate 3 side, and can unfailingly produce the thin film of $Al_2O_3$ at low temperatures. Besides, the thin-film producing apparatus can reduce an amount of chlorine gas for a reduction, because employed $H_2$ gas provides a reduction reaction.

When the above described thin film of Al is produced, a plasma spectroscope 25 detects a light-emitting state of plasma (light-emission strength with respect to wavelength, for instance) in the film-forming process. Specifically, the light-emission strengths of $AICl_3$, $AICl_2$, AICl, the chlorine radical $Cl^*$ and Al are different according to the wavelengths, as is illustrated in FIG. 2, and accordingly the plasma spectroscope 25 can detect the states of $AICl_3$, $AICl_2$, AICl, the chlorine radical $Cl^*$ and Al by detecting the light-emission strengths.

The detected data by the plasma spectroscope 25 is sent to control means 20, and the control means 20 monitors whether $AICl_3$, $AICl_2$, AICl, the chlorine radical $Cl^*$ and Al are formed in a desired state through the above described reaction process. When the desired product has not been obtained (when the state of light-emission strengths does not match with a previously memorized state) as a result of monitoring, the control means 20 commands a vacuum unit 19 to adjust an unshown valve and control the pressure so that $AICl_3$, $AICl_2$, AICl, the chlorine radical $Cl^*$ and Al can be formed in the desired state.

Such amounts of $O_2$ gas and $H_2$ gas as to match with states of $AICl_2$ and AICl are determined on the basis of the result of monitoring, and flow rates of the $O_2$ gas and the $H_2$ gas are controlled by commands on the flow rate adjustments sent to flow rate controllers 23 and 43.

The above described A1C1 forms the Al component through the reaction of:

$$AICl+Cl^* \rightarrow Al+Cl_2\uparrow, \text{ which is caused by the chlorine radical } Cl^*.$$

In addition, the $AICl_2$ forms the Al component through the reaction of:

$$AICl_2+AICl_2 \rightarrow 2Al\downarrow+2Cl_2\uparrow, \text{ which is caused in the plasma.}$$

The thin-film producing apparatus repeats the feed and stop of the $O_2$ gas and the $H_2$ gas on the basis of the detected data by the plasma spectroscope 25, thereby makes the above described reaction and a formation reaction of $Al_2O_3$ alternately conducted, and can produce a stacked film of Al and $Al_2O_3$ on a substrate 3.

It is also possible at this time to produce a thin film in a state in which the composition of Al and $Al_2O_3$ are inclined on the substrate 3, by controlling the flow rates of the $O_2$ gas and the $H_2$ gas.

Furthermore, it is also possible to produce a stacked film of Al and AlN on the substrate 3 on which $Al_2O_3$ has been produced beforehand. In this case, the stacked film can be used as a gate metal having a high dielectric constant. In this case, such an apparatus as to be separately provided with a nozzle for feeding ammonia ($NH_3$) into the chamber 1 can be employed.

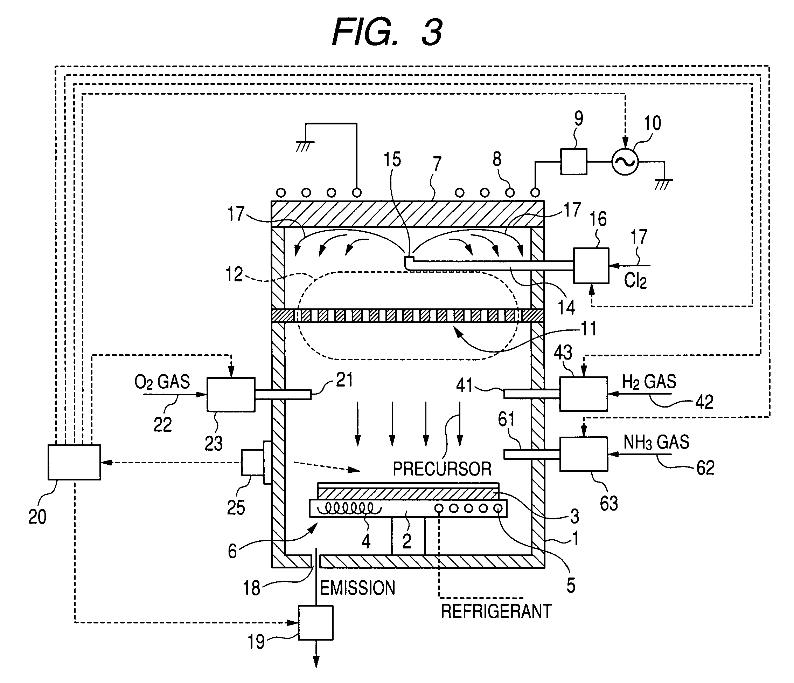

A thin-film producing apparatus for producing a stacked film of Al and AlN will now be described with reference to FIG. 3. The same members as those illustrated in FIG. 1 are denoted by the same reference numerals, and overlapping descriptions are omitted.

Specifically, as is illustrated in FIG. 3, a nozzle 61 for feeding ammonia ($NH_3$) is provided on a cylinder portion of the chamber 1, and feeds $NH_3$ gas 62 into the chamber 1 through a flow rate controller 63. The $NH_3$ gas 62 which has been fed into the chamber 1 is dissociated to $NH_2$ and a hydrogen radical $H^*$ by plasma, and $NH_2$ is formed. Alternatively, the $NH_3$ gas 62 is dissociated to $NH_2$ and HCl through the reaction with a chlorine radical $Cl^*$, and $NH_2$ is formed.

In other words, $NH_3$ causes the reaction of: $NH_3 \rightarrow NH_2+H^*$
, by gas plasma 12, that is to say, is dissociated to $NH_2$ and the hydrogen radical $H^*$, and $NH_2$ is formed.

Furthermore, $NH_3$ causes the reaction of: $NH_3+Cl^* \rightarrow NH_2+HCl\uparrow$
, by the chlorine radical $Cl^*$, that is to say, is dissociated to $NH_2$ and HCl through the reaction with the chlorine radical $Cl^*$, and $NH_2$ is formed.

The formed $NH_2$ and $AICl_2$ cause the reaction of:

$$AICl_2+NH_2 \rightarrow AlN+2HCl\uparrow$$

to deposit the AlN component on a substrate 3.

In addition, the formed $NH_2$, AICl and chlorine radical $Cl^*$ cause the reaction of:

$$AICl+NH_2+Cl^* \rightarrow AlN+2HCl\uparrow$$

to deposit the AlN component on the substrate 3.

Thereby, the thin-film producing apparatus can produce a stacked film of Al and AlN on the substrate 3 on which $Al_2O_3$ has been produced beforehand.

By the way, when the pressure is raised, the chlorine radical $Cl^*$ decreases, which may cause an unequal balance with $AlCl_x$. When a plasma density is increased, the chlorine radical $Cl^*$ and $AlCl_x$ increase, so that control means 20 appropriately adjusts the output of a power source 10 to increase an RF power in synchronization with an action of raising the pressure, and thereby can increase the plasma density. The operation increases the chlorine radical $Cl^*$, eliminates the possibility of decreasing the chlorine radical $Cl^*$ even when having raised the pressure, and can keep the balance with $AlCl_x$.

Incidentally, as for a configuration of increasing the chlorine radical $Cl^*$, a configuration of separately feeding the chlorine radical $Cl^*$ may be adopted other than a method of raising the RF power.

When the thin film of AlN has been produced, it is considered that the thin film is etched by the chlorine radical $Cl^*$ when the temperature of a substrate 3 side is kept high. In order to inhibit the thin film from being etched, the thin-film producing apparatus feeds Ar gas into the chamber 1 when having finished the film formation, generates plasma, thereby lowers an electron temperature in the vicinity of the substrate 3, and can reduce a radiant energy of the surface of the substrate.

Furthermore, it is considered that the thin film of AlN is affected by a Cl radical $Cl^*$ which remains after the plasma has been stopped. In order to inhibit the thin film of AlN from being affected, the thin-film producing apparatus continuously passes He after the plasma has been stopped, makes the He react with the Cl radical $Cl^*$, and can exhaust the resultant gas as $Cl_2$ gas. Thereby, the formed thin film of AlN is not affected by the remaining Cl radical $Cl^*$.

Accordingly, the present invention can provide a thin-film producing apparatus that employs a new type of a CVD apparatus and can unfailingly produce a thin film of $Al_2O_3$ and the stacked film of Al and AlN on the substrate 3 on which $Al_2O_3$ has been produced beforehand, at low temperatures, and a method of producing the thin film.

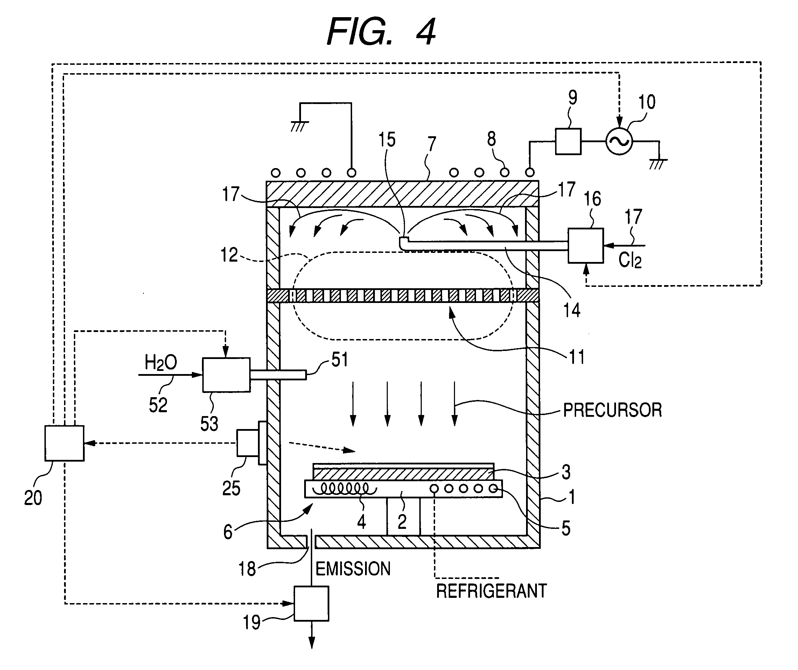

Another embodiment according to the present invention will now be described with reference to FIG. 4. FIG. 4 illustrates a schematic structure of a thin-film producing apparatus according to another embodiment of the present invention. The same members as those illustrated in FIG. 1 are denoted by the same reference numerals, and overlapping descriptions are omitted. In the present exemplary embodiment, the thin-film producing apparatus feeds water vapor ($HO_2$) into a chamber 1, instead of feeding $O_2$ gas and $H_2$ gas into the chamber 1.

The thin-film producing apparatus has a nozzle 51 for feeding water vapor ($HO_2$) 52 provided on a cylinder portion of the chamber 1, and feeds the water vapor ($H_2O$) 52 from the nozzle 51 into the chamber 1 through a flow rate controller 53 (feeding means). The thin-film producing apparatus feeds an action gas 17 containing chlorine into the chamber 1, controls (prolongs) a staying period of a fluid, specifically, increases a pressure in the chamber 1, makes a chlorine radical etch an etching object member containing Al 11 to form a precursor $AlCl_3$ formed by an Al component contained in the etching object member and a halogen Cl, and simultaneously forms $AlCl_2$ and (or) AlCl of intermediate products. The thin-film producing apparatus also feeds the water vapor ($H_2O$) 52 into the chamber 1 from the nozzle 51, and makes the water vapor react with $AlCl_2$ and (or) AlCl in addition to a chlorine radical $Cl^*$ in plasma to form $Al_2O_3$ on a substrate 3 side.

The reaction occurring at this time is expressed by the following formula.

In the plasma, the following reaction occurs:

$$2AlCl_2 + 3H_2O + 2Cl^* \rightarrow Al_2O_3 + 6HCl\uparrow$$

, and a film of $Al_2O_3$ is formed on the substrate 3.

In addition, in the plasma, the following reaction occurs:

$$4AlCl + 3H_2O + 2Cl^* \rightarrow 2Al_2O_3 + 6HCl\uparrow$$

, and the film of $Al_2O_3$ is formed on the substrate 3.

In this way, the thin-film producing apparatus makes the Al component of a precursor $AlX_3$ react with $O_2$ and $H_2$ through easily reducible (unstable) intermediate products to form the film of $Al_2O_3$ on the substrate 3 side, and can unfailingly produce the thin film of $Al_2O_3$ at low temperatures. Besides, because an OH group exists, the thin film of $Al_2O_3$ having excellent adhesiveness can be obtained.

## INDUSTRIAL APPLICABILITY

The present invention can be used in industrial fields of a thin-film producing apparatus which can form a thin film of an Al oxide, and of a method of producing the thin film.

**Claims**

1.  A thin-film producing apparatus comprising:

    a chamber configured to accommodate a substrate therein;
    an etching object member containing Al configured to provide at a position opposing to the substrate in the chamber;
    action gas feeding means for feeding an action gas containing a halogen into the inside of the chamber;
    a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical;
    feeding means for feeding oxygen and hydrogen into the inside of the chamber; and
    a controlling means for generating a intermediate product of $AlX_2$ from the precursor $AlX_3$ by lowering temperature of the substrate side less than temperature of the etching object member and simultaneously controlling the staying period of fluid, and forming Al oxide component generated from reaction of the oxygen and the hydrogen, fed by the feeding means, and the $AlX_2$, on the substrate side.

2.  A thin-film producing apparatus comprising:

    a chamber configured to accommodate a substrate therein;
    an etching object member containing Al configured to provide at a position opposing to the substrate in the chamber;
    action gas feeding means for feeding an action gas containing a halogen into the inside of the chamber;
    a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical;
    feeding means for feeding oxygen and hydrogen into the inside of the chamber; and
    a controlling means for generating a intermediate product of AlX from the precursor $AlX_3$ by lowering temperature of the substrate side less than temperature of the etching object member and simultaneously controlling the staying period of fluid, and forming Al oxide component generated from reaction of the oxygen and the hydrogen, fed by the feeding means, and the AlX, on the substrate side.

3.  The thin-film producing apparatus according to claim 1, wherein
    the feeding means includes a function for adjusting an amount of oxygen and hydrogen according to a state of the precursor $AlX_3$, and
    the control means includes a function for adjusting the amount of oxygen and hydrogen to a desired state to make the Al component and the Al oxide component intermixed on the substrate.

4.  A thin-film producing apparatus comprising:

    a chamber configured to accommodate a substrate therein;
    an etching object member containing Al configured to provide at a position opposing to the substrate in the chamber;
    action gas feeding means for feeding an action gas containing a halogen into the inside of the chamber;
    a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical;
    feeding means for feeding $H_2O$ into the inside of the chamber; and
    a controlling means for generating a intermediate product of $AlX_2$ from the precursor $AlX_3$ by lowering temperature of the substrate side less than temperature of the etching object member and simultaneously controlling the staying period of fluid, and forming Al oxide component generated from reaction of the $H_2O$ fed by the feeding means, and the $AlX_2$, on the substrate side.

5.  A thin-film producing apparatus comprising:

a chamber configured to accommodate a substrate therein;

an etching object member containing Al configured to provide at a position opposing to the substrate in the chamber;

action gas feeding means for feeding an action gas containing a halogen into the inside of the chamber;

a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical;

feeding means for feeding $H_2O$ into the inside of the chamber; and

a controlling means for generating a intermediate product of AlX from the precursor $AlX_3$ by lowering temperature of the substrate side less than temperature of the etching object member and simultaneously controlling the staying period of fluid, and forming Al oxide component generated from reaction of the $H_2O$ fed by the feeding means, and the AlX, on the substrate side.

6. The thin-film producing apparatus according to claim 4, wherein
the feeding means includes a function for adjusting an amount of $H_2O$ according to a state of the precursor $AlX_3$, and the control means includes the function for adjusting an amount of $H_2O$ to a desired state to make the Al component and the Al oxide component intermixed on the substrate.

7. The thin-film producing apparatus according to claim 3, wherein
the function of the control means for making the Al component and the Al oxide component intermixed is a function of alternately stacking the Al component and the Al oxide component on each other.

8. The thin-film producing apparatus according to claim 1, wherein
the staying period is derived from a value calculated by dividing the volume of the chamber by a product of a flow rate of the action gas, a temperature in the atmosphere and a pressure in the chamber, and
the plasma generating means and the control means control the staying period by increasing the pressure in the chamber.

9. The thin-film producing apparatus according to claim 1, wherein
the halogen contained in the action gas is chlorine.

10. The thin-film producing apparatus according to claim 3, further comprising:

$NH_2$ forming means for forming hydrogen and $NH_2$ which is a compound of hydrogen, in the inner part of the chamber; and
AlN-production control means which controls a temperature of the substrate side so as to be lower than a temperature of the etching object member and simultaneously controls the staying period of the fluid to generate an intermediate product of $AlX_2$ from the precursor $AlX_3$, and forming AlN component generated from reaction of the $NH_2$ formed by the $NH_2$ forming means, and the $AlX_2$, on the substrate side, wherein
the control means has a function of producing a thin film of AlN on the substrate on which a film of the Al oxide component has been formed.

11. A method of producing a thin film comprising:

feeding oxygen and hydrogen into a chamber, while feeding an action gas containing a halogen into the chamber;
etching an etching object member containing Al with a halogen radical by controlling a staying period of a fluid to form a precursor $AlX_3$ formed by an Al component contained in the etching object member and the halogen X; and forming an Al oxide component which has been produced through a reaction of the oxygen and the hydrogen with $AlX_2$ on a substrate side, while producing an intermediate product of $AlX_2$ from the precursor $AlX_3$.

12. A method of producing a thin film comprising:

feeding oxygen and hydrogen into a chamber, while feeding an action gas containing a halogen into the chamber;
etching an etching object member containing Al with a halogen radical by controlling a staying period of a fluid to form a precursor $AlX_3$ formed by an Al component contained in the etching object member and the halogen X; and forming an Al oxide component which has been produced through a reaction of the oxygen and the hydrogen with AlX on a substrate side, while producing an intermediate product of AlX from the precursor $AlX_3$.

**13.** A method of producing a thin film comprising:

feeding $H_2O$ into a chamber, while feeding an action gas containing a halogen into the chamber; etching an etching object member containing Al with a halogen radical by controlling a staying period of a fluid to form a precursor $AlX_3$ formed by an Al component contained in the etching object member and the halogen X; and forming an Al oxide component which has been produced through a reaction of the $H_2O$ with $AlX_2$ on a substrate side, while producing an intermediate product of $AlX_2$ from the precursor $AlX_3$.

**14.** A method of producing a thin film comprising:

feeding $H_2O$ into a chamber, while feeding an action gas containing a halogen into the chamber; etching an etching object member containing Al with a halogen radical by controlling a staying period of a fluid to form a precursor $AlX_3$ formed by an Al component contained in the etching object member and the halogen X; and forming an Al oxide component which has been produced through a reaction of the $H_2O$ with AlX on a substrate side, while producing an intermediate product of AlX from the precursor $AlX_3$.

**15.** The method of producing the thin film according to claim 11, wherein the method includes adjusting an amount of oxygen and hydrogen according to a state of the precursor $AlX_3$ to produce the thin film on the substrate, in which the Al component and the Al oxide component are intermixed.

**16.** The method of producing the thin film according to claim 13, wherein the method includes adjusting an amount of $H_2O$ according to a state of the precursor $AlX_3$ to produce the thin film on the substrate, in which the Al component and the Al oxide component are intermixed.

**17.** The method of producing the thin film according to claim 11, wherein the method includes producing a thin film of $Al_2O_3$, and producing a thin film in which an AlN component and an Al component are stacked, on a substrate on which the thin film of $Al_2O_3$ has been produced.

**18.** The method of producing the thin film according to claim 11, wherein the halogen contained in the action gas is chlorine.

FIG. 1

# FIG. 2

# FIG. 3

FIG. 4

## INTERNATIONAL SEARCH REPORT

| | International application No. |
| --- | --- |
| | PCT/JP2006/317438 |

**A. CLASSIFICATION OF SUBJECT MATTER**
*C23C16/40*(2006.01)i, *H01L21/31*(2006.01)i

According to International Patent Classification (IPC) or to both national classification and IPC

**B. FIELDS SEARCHED**

Minimum documentation searched (classification system followed by classification symbols)
C23C16/00-16/56, H01L21/31

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2003-152059 A (Mitsubishi Heavy Industries, Ltd.), 23 May, 2003 (23.05.03), Par. Nos. [0020] to [0027] (Family: none) | 1-18 |
| Y | JP 2003-119565 A (Mitsubishi Heavy Industries, Ltd.), 23 April, 2003 (23.04.03), Par. Nos. [0032] to [0034] & US 2003/0031791 A1 & EP 1284305 A3 | 1-18 |
| Y | JP 2003-247071 A (Mitsubishi Heavy Industries, Ltd.), 05 September, 2003 (05.09.03), Par. Nos. [0031], [0034] to [0035], [0038] & US 2003/0091739 A1 | 1-18 |

| ☒ Further documents are listed in the continuation of Box C. | ☐ See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 12 October, 2006 (12.10.06) | 24 October, 2006 (24.10.06) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/317438

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-327273 A (Mitsubishi Heavy Industries, Ltd.), 15 November, 2002 (15.11.02), Par. Nos. [0016] to [0023] (Family: none) | 1-3,11,12,15 |
| Y | JP 2001-240972 A (Denso Corp.), 04 September, 2001 (04.09.01), Par. No. [0008] (Family: none) | 4-6,13,14,16 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003147534 A